Europäisches Patentamt

European Patent Office

Office européen des brevets

(11) Publication number: **0 248 608**
**A1**

## EUROPEAN PATENT APPLICATION

(21) Application number: **87304785.6**

(22) Date of filing: **29.05.87**

(51) Int. Cl.⁴: **H03K 19/003**

(30) Priority: **03.06.86 JP 128586/86**

(43) Date of publication of application:
**09.12.87 Bulletin 87/50**

(84) Designated Contracting States:
**DE FR GB NL**

(71) Applicant: **SONY CORPORATION**
**7-35 Kitashinagawa 6-Chome Shinagawa-ku**
**Tokyo 141(JP)**

(72) Inventor: **Watanabe, Kazuo**
**Division Sony 6-7-35 Kitashinagawa**
**Shinagawa-ku Tokyo 141(JP)**

(74) Representative: **Thomas, Christopher Hugo et al**
**D Young & Co 10 Staple Inn**
**London WC1V 7RD(GB)**

(54) **Output buffer circuits.**

(57) In an output buffer circuit, for example for a memory device, dummy MOS transistors (1, 2) are connected in parallel with output MOS transistors (3, 4) of the buffer circuit and to an output terminal (5), but not to an input terminal (6) of the buffer circuit.

EP 0 248 608 A1

FIG. 1

## OUTPUT BUFFER CIRCUITS

This invention relates to output buffer circuits. Such buffer circuits are particularly, but not exclusively, suitable for use in semiconductor memory devices, and the invention also relates to such memory devices.

In a previously proposed memory device shown in Figure 3 of the accompanying drawings, a driving circuit 32 is connected to an output of a sensing amplifier 31 which receives at its input the output of memory cells in which information signals are stored and which senses read-out signals corresponding to address signals. The driving circuit 32 is connected to an input terminal 33 of an output buffer circuit which comprises a PMOS transistor 34 and a NMOS transistor 35. The input terminal 33 is connected to the gates of both of the transistors 34 and 35. The source of the transistor 34 is connected to a suitable power supply voltage, and the source of the transistor 35 is connected to earth. The drains of the transistors 34 and 35 are connected together and to an output terminal 36. Each of the transistors 34 and 35 serves as an electrostatic protective circuit, so it is not necessary to provide a special protective circuit.

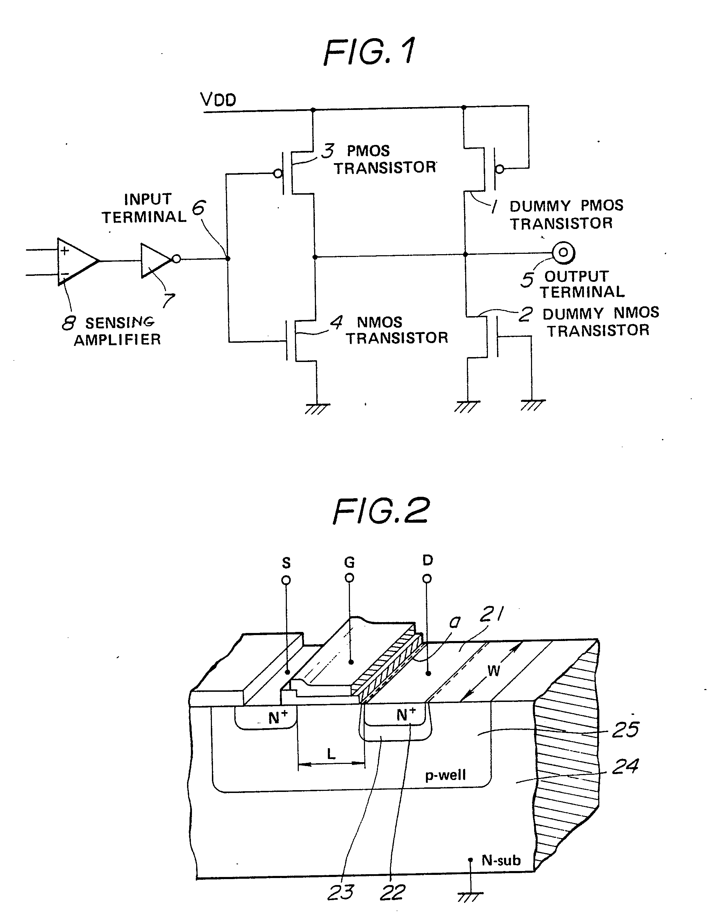

Figure 2 of the accompanying drawings shows a MOS transistor which has a depletion layer 23 associated with a PN junction 22 formed in an impurity region 21 on the drain D during reverse bias. The MOS transistor serves as a proctective diode, and breakdown occurs at a lower voltage than the electrostatic breakdown voltage on an adjacent part of the surface on the channel side of the PN junction 22, so that electrostatic breakdown will be avoided.

However, when miniaturizing memory devices, the channel width W of the MOS transistors in the output buffer circuit becomes narrower. As shown by the dotted line in Figure 4 of the accompanying drawings, when the channel width W becomes narrower, the breakdown voltage increases, so that it is not possible to protect the output buffer circuit effectively from electrostatic breakdown.

Thus, when the channel width W becomes narrower, the volume of a substrate 24 that encloses the PN junction 22, that is a well region 25, becomes relatively large, and as a result the voltage applied to the depletion layer 23 is reduced due to its resistance. Thus, at voltages that may cause insulation breakdown, the resistance does not prevent the breakdown, and the insulation breakdown results. Also, the narrow channel width W results in more current per unit area, which causes the electrostatic breakdown to occur more easily.

On the other hand, the breakdown voltage does not increase unless the channel width W becomes narrower.

However, unless the channel width W is made narrower, the driving ability of the output buffer circuit may become greater than desired. If excess current flows at the time of driving a capacitive load as shown in Figure 3 of the accompanying drawings, harmful effects on the power supply voltage or the earth voltage due to parasitic inductances may occur and cause malfunctions.

If, on the other hand, the channel length L of the MOS transistor of the output buffer circuit is made longer than that of an MOS transistor in the memory cells, the channel width W need not be narrowed and the driving ability of the output buffer circuit can be maintained within the desired range. In that case, however, the gate capacitance, which depends on the area of the gate electrode G of the transistors 34 and 35 increases as illustrated by a broken line in Figure 4. This may cause undesirable effects such as delay in the operating speed, increased power consumption or undesirable pattern area, and may result in the necessity to improve the driving ability of the driving circuit 32.

According to the present invention there is provided an output buffer circuit comprising first MOS transistors connected between an input terminal and an output terminal;

characterized by:

additional MOS transistors connected in parallel with said first MOS transistors and to said output terminal, but not to said input terminal.

The invention will now be described by way of example with reference to the accompanying drawings, in which:

Figure 1 is a circuit diagram of an embodiment of memory device and output buffer circuit according to the present invention;

Figure 2 is an enlarged perspective view, with certain parts shown in cross-section, of an MOS transistor;

Figure 3 is a circuit diagram of a previously proposed memory device including an output buffer circuit; and

Figure 4 is a graph illustrating breakdown characteristics.

In embodiments of the present invention, additional, so-called dummy, MOS transistors are connected to the output terminal of an output buffer circuit in parallel with the usual MOS transistors. The additional MOS transistors serve as diodes relative to the output and, thus, when the channel width W is made narrower, a characteristic can be obtained which is similar to that when the channel width W remains wide.

For example, due to static electricity, electrical charges will flow from the output terminal, which result in voltage being applied to the output terminal. Also, that voltage is applied not only to the PN junction of the impurity region in the MOS transistor of the output buffer circuit, but also to the PN junction of the impurity region which is connected to the output terminal of the MOS transistor that has a function of a protective diode. As the region where the voltage is applied increases, the resistance becomes relatively small and when the resistance reaches a small enough value, a breakdown occurs, without contribution from the resistance, as is shown by the solid line in Figure 4, so avoiding early insulation breakdown. Also, since the region where the current flows increases, the current density is substantially reduced so that electrostatic breakdown will be avoided.

The embodiment shown in Figure 1 includes an output buffer circuit for a memory device in which the information signals are stored, and the circuit preferably comprises CMOS transistors.

A sensing amplifier 8 is connected to a driving circuit 7 which is connected to an input terminal 6 of the output buffer circuit. The input terminal 6 is connected to the gate of a PMOS transistor 3 and the gate of a NMOS transistor 4; the transistors 3 and 4 being the usual transistors for the output buffer circuit. The source of the transistor 3 is connected to a power supply voltage VDD and the source of the transistor 4 is connected to earth. A dummy PMOS transistor 1 which serves as a protective diode has its channel connected in parallel with that of the transistor 3, and has its source connected to the voltage VDD. A dummy NMOS transistor 2 has its channel connected in parallel with that of the transistor 4, has its source connected to earth, and also functions as a protective diode. The drains of the transistors 1 and 2 are connected together and to the output terminal 5, as are the drains of the transistors 3 and 4. The gate of the transistor 1 is connected to its source, and the gate of the transistor 2 is connected to its source.

The sensing amplifier 8 senses faint information signals from the capacitor of the respective memory cell devices and supplies the read level through the driving circuit 7 to the input terminal 6. The driving circuit 7 amplifies the input signals supplied to the output buffer circuit, and during actuation an output is produced from the CMOS output stage of the transistors 3 and 4.

In the embodiment, in addition to the transistors 3 and 4 which are used to drive the load with signals which correspond to the input signals, the dummy transistors 1 and 2 used as protective diodes are connected to the output terminal 5. Thus, if the channel width W of the transistors 3 and 4 are made narrower, a favourable breakdown characteristic can be maintained, and also the electrostatic protective function will be improved.

For example, if static electricity flows in from the output terminal 5, a voltage is applied not only to the impurity regions of the transistors 3 and 4 which are connected to the output terminal 5, but also to the respective PN junctions of the impurity regions of the dummy transistors 1 and 2 which are connected to the output terminal 5. This means that the regions acting as diodes relative to the output have increased. Since the resistance of the substrate or the well is reduced as described above, a favourable breakdown characteristic can be obtained without increasing the channel width W of the MOS transistors of the output buffer circuit.

Since the embodiment comprises CMOS transistors, a breakdown will be caused in the NMOS transistor having a PN junction biased in the reverse direction with excess voltage with positive and negative electrical charges.

In addition, in the embodiment a constant potential is applied to the gates of the dummy transistors 1 and 2, respectively, and the transistors 1 and 2 are not utilized when the output buffer circuit is in operation. This means that during design, one can design the circuit without considering electrostatic effects, and can add the dummy transistors 1 and 2 after fixing the desired channel width W and channel length L. Thus, design is easier, and since the channel width W and the channel length L can be selected, the noise characteristics, the operating speed, the power consumption characteristics and the pattern area can be improved.

## Claims

1. An output buffer circuit comprising first MOS transistors (3, 4) connected between an input terminal (6) and an output terminal (5); characterized by: additional MOS transistors (1, 2) connected in parallel with said first MOS transistors (3, 4) and to said output terminal (5), but not to said input terminal (6).

2. An output buffer circuit according to claim 1 wherein all said MOS transistors (1 to 4) are CMOS transistors (1 to 4).

3. An output buffer circuit according to claim 1 or claim 2 wherein said additional transistors (1, 2) comprise a PMOS transistor (1) and a NMOS transistor (2).

4. A memory device comprising an output buffer circuit according to claim 1, claim 2 or claim 3 a driving circuit (7) supplying its output to said input terminal (6), and a sensing amplifier (8) with its output connected to the input of said driving circuit (7).

## FIG.1

VDD

INPUT TERMINAL 6

8 SENSING AMPLIFIER

7

3 PMOS TRANSISTOR

4 NMOS TRANSISTOR

DUMMY PMOS TRANSISTOR

5 OUTPUT TERMINAL

2 DUMMY NMOS TRANSISTOR

## FIG.2

S    G    D

a    21

W

25

24

N+    N+

L

p-well

23    22

N-sub

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | IEEE JOURNAL OF SOLID-STATE CIRCUITS, vol. SC-20, no. 2, April 1985, pages 594-596, IEEE, New York, US; E. FUJISHIN et al.: "Optimized ESD protection circuits for high-speed MOS/VLSI"<br>* Figure 1; page 594, right-hand column, lines 17-22,31-33; page 596, left-hand column, two last lines * | 1 | H 03 K  19/003 |
| A | Idem | 2,3 | |
| | --- | | |
| A | PATENT ABSTRACTS OF JAPAN, vol. 10, no. 79 (E-391)[2136], 28th March 1986; & JP-A-60 224259 (HITACHI MAIKURO COMPUTER ENGINEERING K.K.) 08-11-1985<br>* Figure * | 1-3 | |
| | --- | | **TECHNICAL FIELDS SEARCHED (Int. Cl.4)** |
| A | PATENT ABSTRACTS OF JAPAN, vol. 9, no. 123 (E-317)[1846], 28th May 1985; & JP-A-60 10 767 (FUJITSU K.K.) 19-01-1985<br>* Figures * | 1 | H 03 K<br>H 01 L |
| | --- | | |
| E | EP-A-0 217 525  (ADVANCED MICRO DEVICES)<br>* Figures 3B,4; column 2, lines 8-12; column 4, line 41 - column 6, line 35 * | 1 | |
| | ----- | | |

The present search report has been drawn up for all claims

| Place of search | Date of completion of the search | Examiner |
|---|---|---|
| THE HAGUE | 09-09-1987 | FEUER F.S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82